# EUROPEAN PATENT APPLICATION

(11) **EP 4 804 402 A1**
(43) Date of publication of application: **09.09.2026**
(21) Application number: 26161608.0
(22) Date of filing: 02.03.2026
(51) Int. Cl.: H03F 1/26, H03F 3/08, H03F 3/45

(54) **AMPLIFIER CIRCUITS WITH GUARDING FOR MITIGATION OF DIELECTRIC ABSORPTION**

(30) Priority: 05.03.2025 US 202519071239
(71) Applicant: Avago Technologies International Sales Pte. Limited, Singapore 768923 (SG)
(72) Inventor: Agarwal, Rishi Chandra, Irvine, CA, 92618 (US)
(74) Representative: Grünecker Patent- und Rechtsanwälte PartG mbB

(57) **Abstract**

Amplifier circuits that can provide improved performance by mitigating the effects of dielectric absorption. An example integrated circuit includes a first pin connectable to a photodiode to receive an input current from the photodiode; a second pin connectable to a capacitor; an amplifier comprising an inverting input terminal and an output terminal; a guard buffer connected between the second pin and the inverting input terminal of the amplifier; and a third pin connected to the output terminal of the amplifier to provide an output voltage indicative of the input current.

## Description

### BACKGROUND

The present disclosure relates, in general, to the design and functionality of electronic circuits for use in a variety of electronic applications and devices. More specifically, the present disclosure relates to the design of amplifier circuits that can be used to mitigate undesirable effects that can result from dielectric absorption of electrical charge in electronic circuits.

### BRIEF DESCRIPTION OF THE DRAWINGS

FIG. 1 shows a diagram illustrating example components of an integrated circuit, in accordance with some aspects of the disclosure.
FIG. 2 shows a diagram illustrating example components of another integrated circuit, in accordance with some aspects of the disclosure.
FIG. 3 shows an example graph illustrating the performance of the integrated circuit of FIG. 1 and the integrated circuit of FIG. 2, in accordance with some aspects of the disclosure.
FIG. 4 shows an example graph illustrating effects of dielectric absorption, in accordance with some aspects of the disclosure.
FIG. 5 shows another example graph illustrating the performance of the integrated circuit of FIG. 1 and the integrated circuit of FIG. 2, in accordance with some aspects of the disclosure.
FIG. 6 an example graph illustrating the performance of the integrated circuit of FIG. 1, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

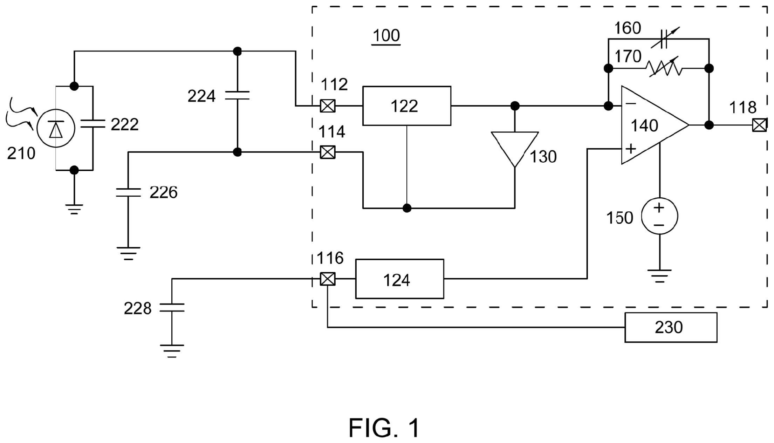

Referring to FIG. 1, a diagram illustrating example components of an integrated circuit 100 is shown, in accordance with some aspects of the disclosure. The integrated circuit 100 can be an amplifier circuit such as, for example, a transimpedance amplifier (TIA) circuit. The integrated circuit 100 can generally be used to convert an input current signal into an output voltage signal. As shown in FIG. 1, the integrated circuit 100 can include various pins, including a pin 112, a pin 114, a pin 116, and a pin 118. Additionally, the integrated circuit 100 can include a filter 122, a filter 124, a guard buffer 130, an amplifier 140, a control signal 150, a capacitor 160, and a resistor 170. As also shown in FIG. 1, the integrated circuit 100 can be connected to various external electronic components including a photodiode 210, a capacitor 222, a capacitor 224, a capacitor 226, a capacitor 228, and a reference generation circuit 230.

The integrated circuit 100 can be provided within a single package that is then connected to a higher level system circuit. For example, the integrated circuit 100 can be provided within a package and connected to a printed circuit board (PCB) of an electronic device. The electronic device can be any suitable type of electronic device such as a wearable device (e.g., smart watch, biometric device, other types of wearable healthcare devices) or a smartphone, for example, among other possibilities. The electronic components including the photodiode 210, the capacitor 222, the capacitor 224, the capacitor 226, the capacitor 228, and the reference generation circuit 230 can be external components in the sense that they may not be provided within the same package as the integrated circuit 100. Rather, in some examples, the photodiode 210, the capacitor 222, the capacitor 224, the capacitor 226, the capacitor 228, and the reference generation circuit 230 can be provided on the printed circuit board that the integrated circuit 100 can be connected to. However, one or more of the photodiode 210, the capacitor 222, the capacitor 224, the capacitor 226, the capacitor 228, and the reference generation circuit 230 can also be provided inside the same package as the components of the integrated circuit 100.

The photodiode 210 can be implemented using various suitable types of photodiode components. For example, the photodiode 210 can be a semiconductor diode that is sensitive to photon radiation (e.g., visible light, infrared light, ultraviolet light, etc.). Generally, the photodiode 210 can produce an electrical current when it absorbs photons, and the integrated circuit 100 can sense the electrical current produced by the photodiode 210. The capacitor 222 can function as a parasitic capacitor associated with the photodiode 210, and can be connected in parallel with the photodiode 210. Then, the capacitor 224 can be connected between the pin 112 and the pin 114 of the integrated circuit 100. The capacitor 224 can function as a coupling capacitor, for example. The capacitor 224 can be included in one or more photodiode (PD) traces on the printed circuit board that the integrated circuit 100 can be connected to. Then, the capacitor 226 can be connected between the pin 114 on the integrated circuit 100 and ground, and the capacitor 228 can similarly be connected between the pin 116 on the integrated circuit 100 and ground. The reference generation circuit 230 can be used to control a reference voltage applied to the pin 116 of the integrated circuit 100.

In many sensing applications involving photodiodes, undesirable effects can occur due to the effects of dielectric absorption. For example, the random orientations of molecular dipoles in the dielectric material disposed between the opposing plates of the capacitor 222 and/or the capacitor 224 may result in the alignment of the dipoles not being completely synchronous with the application of an electric field to the capacitor 222 and/or the capacitor 224 (e.g., as a result of current generated by the photodiode 210). Accordingly, the input current received by a TIA circuit connected to the photodiode 210, the capacitor 222, and the capacitor 224 can be a slow-settling input current (e.g., delay up to a minute, etc.) that can ultimately result in a slow-settling output voltage that is produced by the TIA circuit. This slow-settling effect induced by the dielectric absorption of the capacitor 222 and/or the capacitor 224 can limit the settling to less than 10 bits in absolute terms. For comparison, the noise spectral density for some TIA circuits can be greater than 18 bits. As will be detailed below, the design and functionality of the integrated circuit 100 can provide improvements by mitigating the effects of dielectric absorption and improving the settling of the voltage output generated by the integrated circuit 100.

The pin 112, the pin 114, the pin 116, and the pin 118 can generally be used to form electrical connections between the integrated circuit 100 and the printed circuit board that the integrated circuit 100 can be connected to. The pin 112, the pin 114, the pin 116, and the pin 118 can be implemented in various ways, including by using various types of conductive materials and electrical connector configurations. The pin 112 can generally be connectable to the photodiode 210 to receive an input current from the photodiode 210. As such, the pin 112 can be referred to as a "photodiode" or "PD" pin of the integrated circuit 100. The pin 112 can also be connectable to the capacitor 222 and to a first terminal of the capacitor 224, as shown in FIG. 1. The pin 114 can generally be connectable to the capacitor 224 and the capacitor 226. As shown in FIG 1, the pin 114 can more specifically be connected to a second terminal of the capacitor 224. The pin 114 can be referred to as a "guard" or "GRD" pin of the integrated circuit 100. The pin 116 can be connectable to the capacitor 228 and the reference generation circuit 230, as shown in FIG. 1. The pin 116 can receive a reference voltage and can thus be referred to as a "reference" or "REF" pin of the integrated circuit 100. As shown in FIG. 1, the pin 118 can be connected to an output terminal of the amplifier 140 to provide an output voltage (e.g., to one or more components on the printed circuit board that the integrated circuit 100 can be connected to) indicative of the input current that is received from the photodiode 210 at the pin 112. Accordingly, the pin 118 can be referred to as an "output" or "OUT" pin of the integrated circuit 100. Due to the mitigation of dielectric absorption provided at least in part by the guard buffer 130 of the integrated circuit 100, the output voltage provided by the integrated circuit 100 via the pin 118 can be flatter and faster-settling when compared to the outputs of some previous TIA circuits.

The filter 122 can be implemented using various suitable types and configurations of filters. For example, the filter 122 can be an electromagnetic interference (EMI) filter implemented using various suitable types of electronic components (e.g., capacitors, resistors, inductors, etc.). As shown in FIG. 1, the filter 122 can be connected between the pin 112, an inverting input terminal of the amplifier 140, and an output terminal of the guard buffer 130. The filter 122 can generally be included to mitigate the effects of electromagnetic interference that may occur within the integrated circuit 100. Similarly, the filter 124 can be implemented using various suitable types and configurations of filters. For example, the filter 124 can be an electromagnetic interference filter implemented using various suitable types of electronic components (e.g., capacitors, resistors, inductors, etc.). As shown in FIG. 1, the filter 124 can be connected between the pin 116 and a noninverting input terminal of the amplifier 140. The filter 124 can generally be included to mitigate the effects of electromagnetic interference that may occur within the integrated circuit 100.

The amplifier 140, as noted in part above, can include an inverting input terminal (-), a noninverting input terminal (+), an output terminal, and a power supply terminal. The amplifier 140 can be implemented using various suitable types of amplifier devices and circuits (e.g., various types of operational amplifiers ("op-amps"), etc.). The amplifier 140 can generally be used to amplify the input current that is received from the photodiode 210 at the pin 112 and convert the input current that is received from the photodiode 210 at the pin 112 to a usable output voltage. As shown in FIG. 1, the control signal 150 can control the power supply of the amplifier 140 to supply power to the amplifier 140. The control signal 150 can provide control functionality for powering the amplifier 140 on and off, for example. Also shown in FIG. 1, the capacitor 160 and the resistor 170 can be connected in parallel between the output terminal of the amplifier 140 and the inverting input terminal of the amplifier 140. The capacitor 160 can be a variable capacitor and the resistor 170 can be a variable resistor. An on-chip controller (e.g., a controller provided within the same package as the integrated circuit 100) or an off-chip controller (e.g., a controller provided on the printed circuit board that the integrated circuit 100 can be connected to) can control the variable capacitance of the capacitor 160 and/or the variable resistance of the resistor 170 to adjust various parameters associated with the amplifier 140 (e.g., to adjust the gain, etc.).

The guard buffer 130, as shown in FIG. 1, can be connected between the pin 112 (and between the filter 122), the inverting input terminal of the amplifier 140, and the pin 114. The guard buffer 130 can be implemented using various suitable types and configurations of buffer circuits and/or electrical components used to implement a buffer. For example, the guard buffer 130 can be implemented using one or more transistors (e.g., metal-oxide-semiconductor field-effect transistors (MOSFETs), bipolar junction transistors (BJTs), etc.), one or more amplifiers, one or more diodes, and/or any other suitable electronic components and circuits. Generally, the guard buffer 130 can be used to equalize the voltage across the capacitor 224 and/or the filter 122 on the input of the integrated circuit 100 to mitigate the effects of dielectric absorption. The guard buffer 130 can be driven by the inverting input terminal ("virtual ground") of the amplifier 140. The guard buffer 130 can also be used to guard the filter 122. As a result of the guarding provided by the guard buffer 130, the integrated circuit 100 can provide high precision accuracy of the output via the pin 118 independent of the design of the printed circuit board that the integrated circuit 100 may be connected to. Moreover, high frequency noise peaking that may occur due to the capacitors (e.g., the capacitor 224, the filter 122) can be eliminated, which can help improve the performance of the integrated circuit 100 in low-power, high signal-to-noise ratio (SNR) system designs.

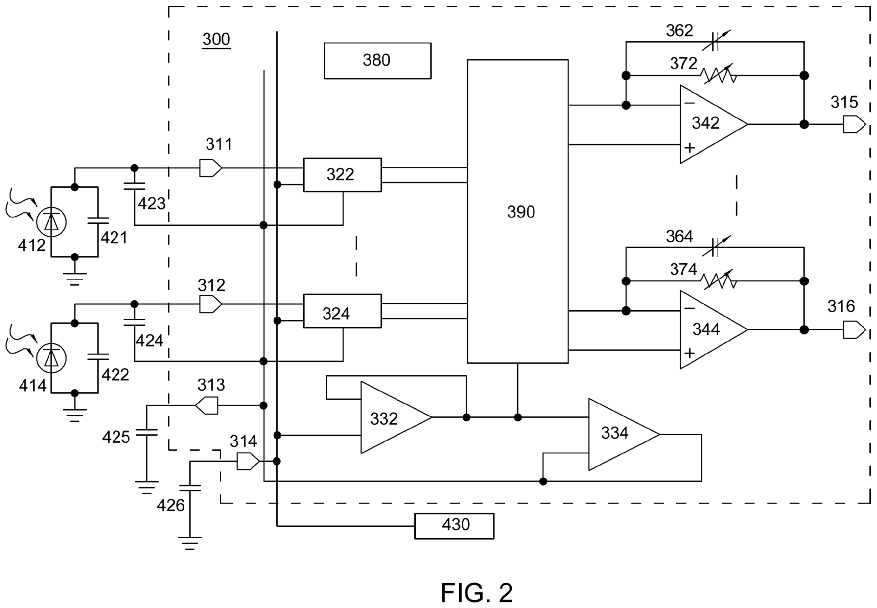

Referring to FIG. 2, a diagram illustrating example components of another integrated circuit 300 is shown, in accordance with some aspects of the disclosure. The integrated circuit 300 can again be an amplifier circuit such as, for example, a TIA circuit. Like the integrated circuit 100, the integrated circuit 300 can generally be used to convert an input current signal into an output voltage signal. However, compared to the "dedicated" guard buffer 130 as used in the integrated circuit 100, the integrated circuit 300 can use a "shared" guard buffer 334. As shown in FIG. 2, the integrated circuit 300 can include various pins, including a pin 311, a pin 312, a pin 313, a pin 314, a pin 315, and a pin 316. Additionally, the integrated circuit 300 can include a filter 322, a filter 324, a precharge buffer 332, an amplifier 342, an amplifier 344, a capacitor 362, a capacitor 364, a resistor 372, a resistor 374, a timing controller 380, and a multiplexer 390. The integrated circuit 300 can be provided within a single package that is then connected to a higher level system circuit. For example, the integrated circuit 300 can be provided within a package and connected to a printed circuit board of an electronic device. The electronic device can be any type of electronic device such as a wearable device (e.g., smart watch, biometric device, other types of wearable healthcare devices) or a smartphone, for example, among other possibilities.

As also shown in FIG. 2, the integrated circuit 300 can be connected to various external electronic components including a photodiode 412, a photodiode 414, a capacitor 421, a capacitor 422, a capacitor 423, a capacitor 424, a capacitor 425, a capacitor 426, and a reference generation circuit 430. The photodiode 412, the photodiode 414, the capacitor 421, the capacitor 422, the capacitor 423, the capacitor 424, the capacitor 425, the capacitor 426, and the reference generation circuit 430 can be external components in the sense that they may not be provided within the same package as the integrated circuit 300. Rather, in some examples, the photodiode 412, the photodiode 414, the capacitor 421, the capacitor 422, the capacitor 423, the capacitor 424, the capacitor 425, the capacitor 426, and the reference generation circuit 430 can be provided on the printed circuit board that the integrated circuit 300 can be connected to. However, one or more of the photodiode 412, the photodiode 414, the capacitor 421, the capacitor 422, the capacitor 423, the capacitor 424, the capacitor 425, the capacitor 426, and the reference generation circuit 430 can also be provided within the same package as the components of the integrated circuit 300. While in FIG. 2 the integrated circuit 300 is shown to be connectable to two photodiodes (the photodiode 412 and the photodiode 414), the design of the integrated circuit 300 allows it to be adaptable for use with any number of photodiodes (e.g., three photodiodes, four photodiodes, etc.) via the precharge buffer 332, the guard buffer 334, the multiplexer 390, and additional amplifiers (e.g., in addition to the amplifier 342 and the amplifier 344) for each added photodiode. These photodiodes can connect to any of the amplifiers of the integrated circuit 300 (e.g., the amplifier 342, the amplifier 344, additional amplifiers that may be included) through the multiplexer 390. The multiplexer 390 can accordingly provide control over which photodiodes will connect to which amplifiers, thereby making the number of photodiodes and the number of amplifiers used in the integrated circuit 300 relatively independent of each other.

The photodiode 412 and the photodiode 414 can be implemented using various suitable types of photodiode components. For example, the photodiode 412 and the photodiode 414 can be semiconductor diodes that are sensitive to photon radiation (e.g., visible light, infrared light, ultraviolet light, etc.). The photodiode 412 and the photodiode 414 can produce electrical currents when they absorb photons, and the integrated circuit 300 can sense the electrical currents produced by the photodiode 412 and the photodiode 414. The capacitor 421 can be included in parallel with the photodiode 412 and the capacitor 422 can be included in parallel with the photodiode 414. The capacitor 421 can be a parasitic capacitor associated with the photodiode 412 and the capacitor 422 can be a parasitic capacitor associated with the photodiode 414, for example.

The capacitor 423 can be connected between the photodiode 412, the guard buffer 334, and the filter 322. The capacitor 423 can be a coupling capacitor present on the printed circuit board that the integrated circuit 300 may be connected to, for example. Similarly, the capacitor 424 can be connected between the photodiode 414, the guard buffer 334, and the filter 324. The capacitor 424 can also be a coupling capacitor present on the printed circuit board that the integrated circuit 300 may be connected to. Then, the capacitor 425 can be connected between the pin 313 on the integrated circuit 300 and ground, and the capacitor 426 can be connected between the pin 314 on the integrated circuit 300 and ground. The reference generation circuit 430 can be used to provide a reference voltage applied to the pin 314 of the integrated circuit 300.

The pin 311, the pin 312, the pin 313, the pin 314, the pin 315, and the pin 316 generally can be used to form electrical connections between the integrated circuit 300 and the printed circuit board that the integrated circuit 300 can be connected to. The pin 311, the pin 312, the pin 313, the pin 314, the pin 315, and the pin 316 can be implemented in various ways, including by using various types of conductive materials. The pin 311 can generally be connectable to the photodiode 412 to receive a first input current from the photodiode 412. As such, the pin 311 can be referred to as a "photodiode 1" or "PD1" pin of the integrated circuit 300. Similarly, the pin 312 can be connectable to the photodiode 414 to receive a second input current from the photodiode 414. As such, the pin 312 can be referred to as a "photodiode 2" or "PD2" pin of the integrated circuit 300. The pin 313 can be connected to the guard buffer 334 and to the capacitor 425. The pin 313 can be referred to as a "guard" or "GRD" pin of the integrated circuit 300.

The pin 314 can be connectable to the capacitor 426 and the reference generation circuit 430, as shown in FIG. 2. The pin 314 can thereby receive a reference voltage, and can be referred to as a "reference" or "REF" pin of the integrated circuit 300. The pin 314 can also be connected to a noninverting input terminal of the amplifier 342 and to a noninverting input terminal of the amplifier 344 (e.g., via the filter 322 and the filter 324, respectively, and the multiplexer 390). Then, the pin 315 can be to an output terminal of the amplifier 342 to provide a first output voltage indicative of the first input current received from the photodiode 412, and the pin 316 can be connected to an output terminal of the amplifier 344 to provide a second output voltage indicative of the second input current received from the photodiode 414. Accordingly, the pin 315 can be referred to as a "TIA1" pin of the integrated circuit 300, and the pin 316 can be referred to as a "TIA2" pin of the integrated circuit 300, for example. Due to the mitigation of dielectric absorption provided at least in part by the guard buffer 334 of the integrated circuit 300, the output voltages provided by the integrated circuit 300 via the pin 315 and the pin 316 can be flatter and faster-settling when compared to the outputs of some previous TIA circuits.

The filter 322 can be implemented using various suitable types and configurations of filters. For example, the filter 322 can be an electromagnetic interference (EMI) filter implemented using various suitable types of electronic components (e.g., capacitors, resistors, inductors, etc.). As shown in FIG. 2, the filter 322 can be connected between the pin 311 and an inverting input terminal of the amplifier 342 (e.g., through the multiplexer 390). The filter 322 can generally be included to mitigate the effects of electromagnetic interference that may occur within the integrated circuit 300. Similarly, the filter 324 can be implemented using various suitable types and configurations of filters. For example, the filter 324 can be an electromagnetic interference filter implemented using various suitable types of electronic components (e.g., capacitors, resistors, inductors, etc.). As shown in FIG. 2, the filter 324 can be connected between the pin 312 and an inverting input terminal of the amplifier 344. The filter 324 can generally be included to mitigate the effects of electromagnetic interference that may occur within the integrated circuit 300.

The amplifier 342 and the amplifier 344, as noted in part above, can each include an inverting input terminal (-), a noninverting input terminal (+), and an output terminal. Also, the amplifier 342 the amplifier 344 can be implemented using various suitable types of amplifier devices and circuits (e.g., various types of operational amplifiers ("op-amps"), etc.). The amplifier 342 can generally be used to amplify the first input current that is received from the photodiode 412 at the pin 311 (e.g., based on a selection by the multiplexer 390) and convert the first input current that is received from the photodiode 412 at the pin 311 to a usable output voltage. The amplifier 344 can be used to amplify the second input current that is received from the photodiode 414 at the pin 312 (e.g., based on a selection by the multiplexer 390) and convert the second input current that is received from the photodiode 414 at the pin 312 to a usable output voltage.

As shown in FIG. 2, the capacitor 362 and the resistor 372 can be connected in parallel between the output terminal of the amplifier 342 and the inverting input terminal of the amplifier 342. The capacitor 362 can be a variable capacitor and the resistor 372 can be a variable resistor. Similarly, the capacitor 364 and the resistor 374 can be connected in parallel between the output terminal of the amplifier 344 and the inverting input terminal of the amplifier 344. The capacitor 364 can be a variable capacitor and the resistor 374 can be a variable resistor. An on-chip controller (e.g., a controller provided within the same package as the integrated circuit 300, the timing controller 380) or an off-chip controller (e.g., a controller provided on the printed circuit board that the integrated circuit 300 can be connected to) can control the variable capacitance of the capacitor 362, the variable capacitance of the capacitor 364, the variable resistance of the resistor 372, and or the variable resistance of the resistor 374 to adjust various parameters associated with the amplifier 342 and the amplifier 344 (e.g., to adjust the gain, etc.), respectively.

As shown in FIG. 2, the guard buffer 334 can be connected between the pin 313 and the inverting input terminal of the amplifier 342, and between the pin 313 and the inverting input terminal of the amplifier 344. The guard buffer 334 can also be connected between an output terminal of the precharge buffer 332 and the pin 313. The precharge buffer 332 can be connected to the pin 311, the pin 312, and the guard buffer 334. Additionally, the precharge buffer 332 can be connected to the pin 314 and the guard buffer 334. The precharge buffer 332 and the guard buffer 334 can be implemented using can be implemented using various suitable types and configurations of buffer circuits and/or electrical components used to implement a buffer. For example, the guard buffer 334 can be implemented using one or more transistors (e.g., MOSFETs, BJTs, etc.), one or more amplifiers, one or more diodes, and/or any other suitable electronic components and circuits. As shown for example in the diagram of FIG. 2, the precharge buffer 332 and the guard buffer 334 can each be implemented using an amplifier. More specifically, the precharge buffer 332 can be implemented using an amplifier having an inverting input terminal and an output terminal, where the inverting input terminal can be connected to the output terminal of the amplifier.

The guard buffer 334 can generally be used to equalize the voltage across the capacitors at the photodiode inputs (e.g., the voltage across the capacitor 423 and the capacitor 424). The guard buffer 334 can generally be driven off of the precharge buffer 332, and the precharge buffer 332 can generally precharge the photodiode 412 and the photodiode 414 (e.g., in a given scan). Accordingly, the guard buffer 334 can be used to guard the photodiode 412, the photodiode 414, the capacitor 423, the capacitor 424, the filter 322, and the filter 324. By equalizing the voltage across the capacitor 423 and the capacitor 424, for example, the guard buffer 334 can mitigate the undesirable effects of dielectric absorption that can otherwise occur with respect to the capacitor 423 and the capacitor 424. Accordingly, the integrated circuit 300 can provide high precision accuracy of the outputs provided via the pin 315 and the pin 316, respectively, independent of the design of the printed circuit board that the integrated circuit 300 may be connected to.

The multiplexer 390 can be implemented using various suitable types of multiplexer circuits and/or components. The size and configuration of the multiplexer 390 can vary depending on the number of photodiodes and the number of amplifiers associated with the integrated circuit 300, for example. The multiplexer 390 can be connected between the filter 322, the filter 324, the amplifier 342, the amplifier 344, the precharge buffer 332, and the guard buffer 334, for example. The multiplexer 390 can thereby be used to connect the photodiode 412 and the photodiode 414 to the amplifier 342 and the amplifier 344.

The timing controller 380 can be implemented using various suitable types and configurations of timing controllers, including using one or multiple separate circuits and/or components. The timing controller 380 can be connected to the precharge buffer 332, the guard buffer 334, and the multiplexer 390, for example, among other possible components of the integrated circuit 300. The timing controller 380 can be configured to control various aspects of the operation of the integrated circuit 300. For example, the timing controller 380 can be configured to turn the precharge buffer 332 on and off, to turn the guard buffer 334 on and off, and also to enable and disable the amplifier 342 and the amplifier 344. The timing controller 380 can include various suitable types of memory and processing circuitry, including one or more non-transitory computer-readable storage media having machine-readable instructions stored thereon for execution by the processing circuitry, to implement a timing sequence associated with the integrated circuit 300. The timing sequence implemented by the timing controller 380 can include: (1) turning on the precharge buffer 332; (2) configuring the photodiodes (e.g., the photodiode 412, the photodiode 414) that are planned to be used in the scan to precharge; (3) turning on the guard buffer 334; (4) enabling/disabling the respective TIAs (e.g., the amplifier 342, the amplifier 344) as part of the scan plan; and (5) at the end of the scan plan, turning off the precharge buffer 342 and the guard buffer 344. Also, between scan plans in the timing sequence, the timing controller 380 can maintain a buffer time period (e.g., one millisecond, two milliseconds, etc.) between scan plans if the photodiodes to be used in a subsequent scan plan are going to be different.

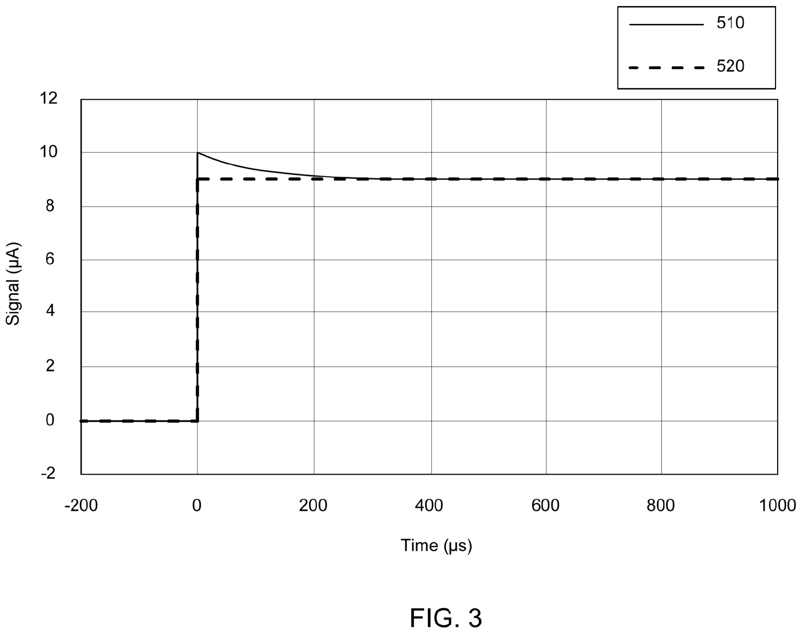

Referring to FIG. 3, an example graph illustrating the performance of the integrated circuit 100 and the integrated circuit 300 is shown, in accordance with some aspects of the disclosure. In particular, the graph shown in FIG. 3 illustrates the detected photodiode input current signal with and without the effects of dielectric absorption. The graph of FIG. 3 plots the detected current signal on the y-axis (in units of microamperes) versus the time (in units of microseconds) on the x-axis. At time 0, the detected current spikes as a result of photons detected by the photodiode. The line 510 shows the input current with the effects of dielectric absorption, and the line 520 shows the input current response without the effects of dielectric absorption. As can be seen, the detected input current without the effects of dielectric absorption (e.g., the input current received at the pin 112 form the photodiode 210, the first input current received at the pin 311 from the photodiode 412, the second input current received at the pin 312 from the photodiode 414) settles more quickly and provides a flatter, more precisely detected input current.

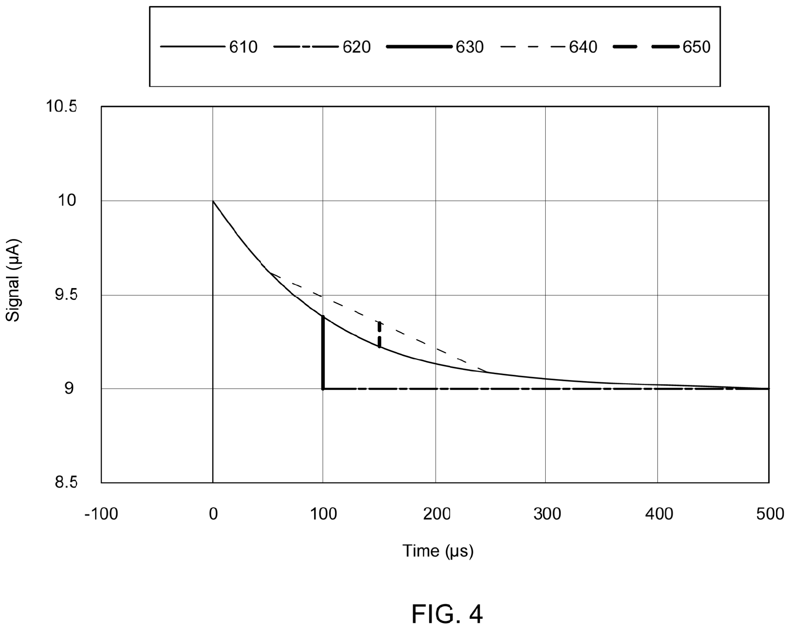

Referring to FIG. 4, an example graph illustrating the effects of dielectric absorption is shown, in accordance with some aspects of the disclosure. In evaluating the performance of the integrated circuit 100 and the integrated circuit 300, important parameters to measure include the final value error and the linear average error. The final value error provides an indication of the magnitude of the effects of dielectric absorption at a certain timepoint. The linear average error provides an indication of the linearity of the settling of the effects of dielectric absorption at a certain timepoint. The linear average error can be more important than the final value error in some examples since a completely linear settling may only introduce a fixed offset. The graph shown in FIG. 4 again illustrates the photodiode input current signal. The graph of FIG. 4 again plots the current signal on the y-axis (in units of microamperes) versus the time (in units of microseconds) on the x-axis. At time 0, the current spikes as a result of photons detected by the photodiode. The line 610 shows the input current, the line 620 shows the final value, the line 630 shows the final value error, the line 640 shows the linear average, and the line 650 shows the linear average error. In this example, the final value error can be measured at 100 microseconds and the linear average error can be measured at 150 microseconds. These errors can be reduced (if not eliminated) by using designs such as detailed above with respect to the integrated circuit 100 and the integrated circuit 300.

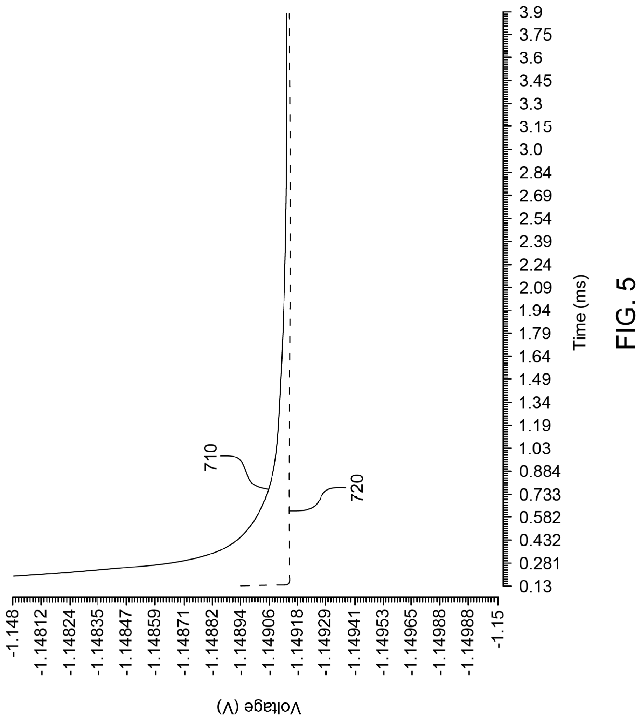

Referring to FIG. 5, another example graph illustrating the performance of the integrated circuit 100 and the integrated circuit 300 is shown, in accordance with some aspects of the disclosure. In particular, the graph shown in FIG. 5 illustrates the output voltage provided by the integrated circuit 100 and the integrated circuit 300 (e.g., via the pin 118, the pin 315, the pin 316) compared to the output voltage provided by similar circuits that do not include the dielectric absorption mitigation features of the integrated circuit 100 and the integrated circuit 300. The graph of FIG. 5 shows the output voltage plotted on the y-axis (in units of volts) versus time (in milliseconds) on the x-axis. The line 710 shows the output voltage provided by similar circuits that do not include a guard buffer, and the line 720 shows the output voltage provided by the integrated circuit 100 and the integrated circuit 300 that do include the guard buffer 130 and the guard buffer 334, respectively. As can be seen, the final value error and the linear average error can be significantly reduced when using the dielectric absorption mitigation features of the integrated circuit 100 and the integrated circuit 300. In some examples, the final value error and the linear average error can each be reduced by about one thousand times when using the dielectric absorption mitigation features of the integrated circuit 100 and the integrated circuit 300.

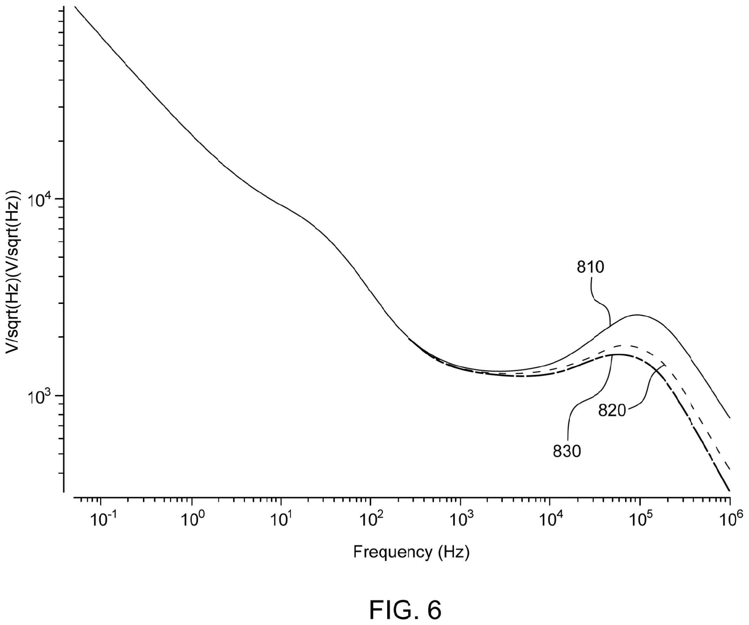

Referring to FIG. 6, an example graph illustrating the performance of the integrated circuit 100 is shown, in accordance with some aspects of the disclosure. In particular, the graph shown in FIG. 6 illustrates the output noise density provided by the integrated circuit 100 (e.g., via the pin 118) compared to the output noise density provided by similar circuits that do not include the dielectric absorption mitigation features of the integrated circuit 100 (e.g., the guard buffer 130). The graph of FIG. 6 shows the output noise density plotted on the y-axis versus frequency on the x-axis. The line 810 shows the output noise density provided by similar circuits that do not include a guard buffer like the guard buffer 130. The line 820 shows the output noise density provided by the integrated circuit 100 with a photodiode capacitance of 25 picofarads (e.g., the capacitance of the capacitor 222), and the line 830 shows the output noise density provided by the integrated circuit 100 with a photodiode capacitance of 0 picofarads. As can be seen, high frequency noise peaking can be significantly reduced using the integrated circuit 100.

The following are further embodiments of the present invention:
1. An integrated circuit, comprising:
   a first pin connectable to a first photodiode to receive a first input current from the first photodiode;
   a first amplifier comprising an inverting input terminal and an output terminal;
   a second pin connectable to a second photodiode to receive a second input current from the second photodiode;
   a second amplifier comprising an inverting input terminal and an output terminal;
   a third pin connectable to a capacitor;
   a guard buffer connected between the third pin and the inverting input terminal of the first amplifier and between the third pin and the inverting input terminal of the second amplifier;
   a precharge buffer connected to the first pin, the second pin, and the guard buffer;
   a fourth pin connected to the output terminal of the first amplifier to provide a first output voltage indicative of the first input current; and
   a fifth pin connected to the output terminal of the second amplifier to provide a second output voltage indicative of the second input current.
2. The integrated circuit of embodiment 1, comprising:
   a first filter connected between the first pin and the inverting input terminal of the first amplifier; and
   a second filter connected between the second pin and the inverting input terminal of the second amplifier.
3. The integrated circuit of embodiment 2, comprising a multiplexer connected between the first filter, the second filter, the first amplifier, the second amplifier, the guard buffer, and the precharge buffer.
4. The integrated circuit of embodiment 1, comprising a sixth pin connected to a noninverting input terminal of the first amplifier and to a noninverting input terminal of the second amplifier, the sixth pin connectable to a reference current.
5. The integrated circuit of embodiment 1, wherein the precharge buffer comprises a third amplifier and the guard buffer comprises a fourth amplifier.
6. The integrated circuit of embodiment 5, wherein the third amplifier comprises an inverting input terminal and an output terminal, the inverting input terminal of the third amplifier connected to the output terminal of the third amplifier.
7. The integrated circuit of embodiment 3, comprising a timing controller connected to the guard buffer, the precharge buffer, and the multiplexer.
8. The integrated circuit of embodiment 7, wherein the timing controller is configured to turn the guard buffer on and off.
9. The integrated circuit of embodiment 8, wherein the timing controller is configured to turn the precharge buffer on and off.
10. The integrated circuit of embodiment 9, wherein the timing controller is configured to enable and disable the first amplifier and the second amplifier.
11. An integrated circuit, comprising:
   a first pin connectable to a photodiode to receive an input current from the photodiode;
   a second pin connectable to a capacitor;
   an amplifier comprising an inverting input terminal and an output terminal;
   a filter connected between the first pin and the inverting input terminal of the amplifier;
   a guard buffer connected between the second pin and the inverting input terminal of the amplifier; and
   a third pin connected to the output terminal of the amplifier to provide an output voltage indicative of the input current.
12. The integrated circuit of embodiment 11, comprising a fourth pin connected to a noninverting input terminal of the amplifier, the fourth pin connectable to a reference current.
13. The integrated circuit of embodiment 12, comprising a second filter connected between the fourth pin and the noninverting input terminal of the amplifier.
14. The integrated circuit of embodiment 11, wherein the integrated circuit is connectable to a printed circuit board, the printed circuit board comprising the capacitor.
15. The integrated circuit of embodiment 14, wherein the first pin is connectable to a first terminal of a second capacitor on the printed circuit board and the second pin is connectable to a second terminal of the second capacitor on the printed circuit board.
16. The integrated circuit of embodiment 11, wherein the guard buffer comprises a transistor.
17. An integrated circuit, comprising:
   a first pin connectable to a photodiode to receive an input current from the photodiode;
   a second pin connectable to a capacitor;
   an amplifier comprising an inverting input terminal and an output terminal;
   a guard buffer connected between the second pin and the inverting input terminal of the amplifier; and
   a third pin connected to the output terminal of the amplifier to provide an output voltage indicative of the input current.
18. The integrated circuit of embodiment 17, comprising a filter connected between the first pin and the inverting input terminal of the amplifier.
19. The integrated circuit of embodiment 18, comprising a fourth pin connected to a noninverting input terminal of the amplifier, the fourth pin connectable to a reference current.
20. The integrated circuit of embodiment 19, comprising a second filter connected between the fourth pin and the noninverting input terminal of the amplifier.

## Claims

1. An integrated circuit, comprising:
a first pin connectable to a first photodiode to receive a first input current from the first photodiode;
a first amplifier comprising an inverting input terminal and an output terminal;
a second pin connectable to a second photodiode to receive a second input current from the second photodiode;
a second amplifier comprising an inverting input terminal and an output terminal;
a third pin connectable to a capacitor;
a guard buffer connected between the third pin and the inverting input terminal of the first amplifier and between the third pin and the inverting input terminal of the second amplifier;
a precharge buffer connected to the first pin, the second pin, and the guard buffer;
a fourth pin connected to the output terminal of the first amplifier to provide a first output voltage indicative of the first input current; and
a fifth pin connected to the output terminal of the second amplifier to provide a second output voltage indicative of the second input current.

2. The integrated circuit of claim 1, comprising:
a first filter connected between the first pin and the inverting input terminal of the first amplifier; and
a second filter connected between the second pin and the inverting input terminal of the second amplifier.

3. The integrated circuit of claim 2, comprising a multiplexer connected between the first filter, the second filter, the first amplifier, the second amplifier, the guard buffer, and the precharge buffer.

4. The integrated circuit of one of the previous claims, comprising a sixth pin connected to a noninverting input terminal of the first amplifier and to a noninverting input terminal of the second amplifier, the sixth pin connectable to a reference current.

5. The integrated circuit of one of the previous claims, wherein the precharge buffer comprises a third amplifier and the guard buffer comprises a fourth amplifier,
in particular,
wherein the third amplifier comprises an inverting input terminal and an output terminal, the inverting input terminal of the third amplifier connected to the output terminal of the third amplifier.

6. The integrated circuit of claim 3, comprising a timing controller connected to the guard buffer, the precharge buffer, and the multiplexer.

7. The integrated circuit of claim 6, wherein the timing controller is configured to turn the guard buffer on and off.

8. The integrated circuit of claim 7, wherein the timing controller is configured to turn the precharge buffer on and off,
in particular,
wherein the timing controller is configured to enable and disable the first amplifier and the second amplifier.

9. An integrated circuit, comprising:
a first pin connectable to a photodiode to receive an input current from the photodiode;
a second pin connectable to a capacitor;
an amplifier comprising an inverting input terminal and an output terminal;
a filter connected between the first pin and the inverting input terminal of the amplifier;
a guard buffer connected between the second pin and the inverting input terminal of the amplifier; and
a third pin connected to the output terminal of the amplifier to provide an output voltage indicative of the input current.

10. The integrated circuit of claim 9, comprising a fourth pin connected to a noninverting input terminal of the amplifier, the fourth pin connectable to a reference current,
in particular,
the integrated circuit comprising a second filter connected between the fourth pin and the noninverting input terminal of the amplifier.

11. The integrated circuit of one of claims 9 or 10, wherein the integrated circuit is connectable to a printed circuit board, the printed circuit board comprising the capacitor,
in particular,
wherein the first pin is connectable to a first terminal of a second capacitor on the printed circuit board and the second pin is connectable to a second terminal of the second capacitor on the printed circuit board.

12. The integrated circuit of one of claims 9 to 11, wherein the guard buffer comprises a transistor.

13. An integrated circuit, comprising:
a first pin connectable to a photodiode to receive an input current from the photodiode;
a second pin connectable to a capacitor;
an amplifier comprising an inverting input terminal and an output terminal;
a guard buffer connected between the second pin and the inverting input terminal of the amplifier; and
a third pin connected to the output terminal of the amplifier to provide an output voltage indicative of the input current.

14. The integrated circuit of claim 13, comprising a filter connected between the first pin and the inverting input terminal of the amplifier.

15. The integrated circuit of claim 14, comprising a fourth pin connected to a noninverting input terminal of the amplifier, the fourth pin connectable to a reference current,
in particular,
the integrated circuit comprising a second filter connected between the fourth pin and the noninverting input terminal of the amplifier.
